# EUROPÄISCHE PATENTSCHRIFT

(11) **EP 3 192 770 B1**
(45) Veröffentlichungstag und Bekanntmachung des Hinweises auf die Patenterteilung: **17.07.2019**
(21) Anmeldenummer: 16150891.6
(22) Anmeldetag: 12.01.2016
(51) Int. Cl.: B81B 3/00, G02B 26/08

(54) **VORRICHTUNG ZUR ZWEIDIMENSIONALEN ABLENKUNG EINES LASERSTRAHLS**
DEVICE FOR TWO-DIMENSIONAL DEFLECTION OF A LASER BEAM
DISPOSITIF DE DEVIATION BIDIMENSIONNELLE D'UN RAYON LASER

(43) Veröffentlichungstag der Anmeldung: 19.07.2017
(73) Patentinhaber: TRUMPF Schweiz AG, 7214 Grüsch (CH)
(72) Erfinder: Dr. Jutzi, Fabio, 7000 Chur (CH); Bayat, Dara, 2000 Neuchâtel (CH); Lani, Sébastien, 1784 Courtepin (CH)
(74) Vertreter: Kohler Schmid Möbus Patentanwälte

(56) Entgegenhaltungen:
- EP-A2- 1 950 174
- US-A1- 2003 053 232
- US-A1- 2004 001 263
- US-A1- 2004 061 962
- ÇA LAR ATAMAN ET AL: "Paper;A dual-axis pointing mirror with moving-magnet actuation;A dual-axis pointing mirror with moving-magnet actuation", JOURNAL OF MICROMECHANICS & MICROENGINEERING, INSTITUTE OF PHYSICS PUBLISHING, BRISTOL, GB, Bd. 23, Nr. 2, 21. Dezember 2012 (2012-12-21), Seite 25002, XP020237864, ISSN: 0960-1317, DOI: 10.1088/0960-1317/23/2/025002

## Beschreibung

Die Erfindung betrifft eine Vorrichtung zur zweidimensionalen Ablenkung eines Laserstrahls, aufweisend ein Substrat mit einer Substratöffnung, eine an dem Substrat vorgesehene Federmembran, die sich in die Substratöffnung erstreckende Federarme und einen in der Substratöffnung angeordneten, von den Federarmen getragenen Mittelabschnitt aufweist, welcher zweidimensional kippbar und in beide Richtungen der sich rechtwinklig zur Federmembranebene erstreckenden Federmembran-Mittelachse axial verschiebbar gelagert ist, einen Spiegel, der an dem Mittelabschnitt der Federmembran befestigt ist, und einen magnetischen oder elektrostatischen Antrieb zum Verkippen des Spiegels gegen die Rückstellkraft der Federarme.

Eine derartige Vorrichtung zur Ablenkung eines Laserstrahls auf Basis einer MEMS-Technologie mit einem elektromagnetischen Antrieb in Form von Flachspulen ist z.B. aus Ataman et al., J. Micromech. Microeng. 23 (2013) 025002 (13pp) oder aus T. Iseki et al., OPTICAL REVIEW Vol. 13, No. 4 (2006) 189-194 bekannt.

Vorrichtungen zur Ablenkung eines Laserstrahls, insbesondere Micro-Scanner in Anordnungen zur Lasermaterialbearbeitung, sollen eine hohe Dynamik bezüglich Winkelgeschwindigkeit und Winkelbeschleunigung sowie eine hohe Genauigkeit bezüglich Winkeleinstellung und Wiederholbarkeit bieten. Gleichzeitig werden die verwendeten Laserstrahlen stetig leistungsstärker und die Bauräume immer kleiner. Eine interessante Technologie bieten hier Scannerspiegel auf Basis von MEMS (Microelectro mechanical systems) und insbesondere Vorrichtungen, die auf elektromagnetischen oder elektrostatischen Antrieben beruhen.

Um bei der aus dem oben genannten Artikel bekannten Ablenkvorrichtung hohe Dynamik und Linearität beim Verkippen des Spiegels zu erreichen, kann die Federmembran insbesondere in axialer Richtung nicht sehr steif ausgelegt werden, so dass bei hohen axialen Kräften (z.B. Beschleunigung durch Stöße, wie sie gerade beim Transport auftreten können) die Federarme der Federmembran plastisch verformt werden oder brechen können.

Der vorliegenden Erfindung liegt daher die Aufgabe zugrunde, bei einer Ablenkvorrichtung der eingangs genannten Art eine plastische Verformung oder einen Bruch der Federmembran zu verhindern, also eine gegen Stöße möglichst unempfindliche Ablenkvorrichtung anzugeben.

Diese Aufgabe wird erfindungsgemäß dadurch gelöst, dass die Federmembran mindestens einen Endanschlagarm aufweist, der eine höhere Federsteifigkeit als die Federarme aufweist und mit einem freien Ende in die Substratöffnung bis in die Bewegungsbahn eines starr am Spiegel befestigten Bauteils hinein vorsteht, um durch Zusammenwirken mit dem Bauteil eine über die beim antriebsbedingten Verkippen des Spiegels hinausgehende, axiale Auslenkung des Mittelabschnittes zumindest in einer axialen Richtung zu begrenzen.

Der erfindungsgemäße mindestens eine Endanschlagarm ist außerhalb des antriebsbedingten, maximalen Kippwinkelbereichs des Spiegels von z.B. ± 10° und außerhalb einer dabei in der axialen Richtung ggf. auftretenden maximalen Verschiebung des Spiegels angeordnet und so positioniert, dass die axiale Maximalauslenkung der Federmembran auf den elastischen Auslenkungsbereich beschränkt bleibt, also bis zur Anlage des Bauteils am Endanschlagarm weder plastische Verformungen noch Brüche der Federmembran auftreten. Der Endanschlagarm kann seinerseits eine hohe Elastizität aufweisen, um beim Anschlagen des Bauteils die Beschleunigungen zu dämpfen und so die Kräfte zu minimieren. Die Federmembran ist typischerweise auf ein Substrat aufgebracht oder aus einem Substrat herausgeätzt, wobei die Federarme z.B. gerade, spiralförmig, zickzack-förmig oder S-förmig verlaufen können.

Erfindungsgemäß stehen der eine oder mehrere Endanschlagarme der Federmembran in die Substratöffnung bis in die Bewegungsbahn des Bauteils hinein vor, um mit ihren federnden freien Enden die axiale Bewegung des Bauteils zu stoppen. Die Endanschlagarme können direkt in die Device-Layer eines SOI(Silicon-on-Insulator)-Siliziumwafers geätzt sein und sind vorteilhaft in gleichen Winkelabständen zueinander und in ausreichendem Abstand zu den Federarmen angeordnet, um deren Bewegung nicht zu blockieren. Erfindungsgemäß weisen die Endanschlagarme eine höhere Federsteifigkeit als die Federarme auf, was z.B. durch einen größeren Querschnitt der Endanschlagarme erreicht werden kann.

Vorzugsweise ist das mit dem mindestens einen Endanschlagarm zusammenwirkende Bauteil auf der dem Spiegel gegenüberliegenden Seite des Mittelabschnittes angeordnet und insbesondere daran befestigt.

Bei besonders bevorzugten Ausführungsformen der Erfindung ist das mit dem mindestens einen Endanschlagarm zusammenwirkende Bauteil die Federmembran oder ein Permanentmagnet oder eine Magnetspule eines magnetischen Antriebs oder eine Elektrode eines elektrostatischen Antriebs, also eine sowieso am Spiegel befestigte Antriebskomponente des magnetischen oder elektrostatischen Antriebs. Alternativ kann das mit dem mindestens einen Endanschlagarm zusammenwirkende Bauteil auch ein Bauteil ohne Antriebfunktion sein, wie z.B. eine Anschlagscheibe. Bevorzugt ist das weitere Bauteil durch eine separate Anschlagplatte oder durch mindestens einen radial nach außen vorstehenden Vorsprung eines zwischen Permanentmagnet und Federmembran befindlichen Abstandshalters gebildet.

Vorzugsweise ist die axiale Auslenkung des Mittelabschnittes auch in der anderen axialen Richtung durch eine weitere Endanschlageinrichtung begrenzt, die ebenfalls mit einem starr am Spiegel befestigten Bauteil zusammenwirkt und prinzipiell gleich wie der oben beschriebene mindestens eine Endanschlagarm aufgebaut sein kann. Die weitere Endanschlageinrichtung ist ebenfalls außerhalb des antriebsbedingten, maximalen Kippwinkelbereichs des Spiegels von z.B. ± 10° und außerhalb einer dabei in der anderen axialen Richtung ggf. auftretenden maximalen Verschiebung des Spiegels angeordnet und so positioniert, dass die axiale Maximalauslenkung der Federmembran auf den elastischen Auslenkungsbereich beschränkt bleibt, also bis zur Anlage des Bauteils an der weiteren Endanschlageinrichtung weder plastische Verformungen noch Brüche der Federmembran auftreten. Die Endanschlageinrichtung kann ihrerseits eine hohe Elastizität aufweisen, um beim Anschlagen des Bauteils die Beschleunigungen zu dämpfen und so die Kräfte zu minimieren.

Bevorzugt ist die weitere Endanschlageinrichtung jedoch durch einen in der Bewegungsbahn des Bauteils angeordneten Endanschlag, wie z.B. eine vor der Substratöffnung angeordnete Anschlagplatte, Flachspulen-Leiterplatte oder einen mittig vor dem Bauteil angeordneten, axialen Dorn verwirklicht.

Vorteilhaft kann zwischen dem mindestens einen Endanschlagarm bzw. der weitern Endanschlageinrichtung und dem damit zusammenwirkenden Bauteil ein Dämpfer angeordnet, insbesondere an dem mindestens einen Endanschlagarm, der weiteren Endanschlageinrichtung oder am Bauteil befestigt sein. Der Dämpfer kann beispielsweise am Bauteil durch einen Polymerüberzug, wie z.B. eine Parylenebeschichtung, realisiert sein.

Vorzugsweise ist die erfindungsgemäße Ablenkvorrichtung in MEMS(MicroElectro-Mechanical Systems)-Technologie ausgeführt.

Weitere Vorteile und vorteilhafte Ausgestaltungen des Gegenstands der Erfindung ergeben sich aus der Beschreibung, den Ansprüchen und den Zeichnungen. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung. Es zeigen:
- Fign. 1a, 1b: einen Längsschnitt einer erfindungsgemäßen Vorrichtung zum zweidimensionalen Ablenken eines Laserstrahls mit einem verkippbaren Spiegel, der in Fig. 1a in einer axial nicht ausgelenkten Position und in Fig. 1b in seiner axial ausgelenkten, oberen Endposition gezeigt ist;
- Fig. 2: eine Draufsicht auf eine in Fig. 1 gezeigte Federmembran;
- Fig. 3: die in Fig. 1 gezeigte Ablenkvorrichtung mit einer modifizierten unteren Endanschlageinrichtung, in einer Ansicht analog zu Fig. 1a;
- Fign. 4a, 4b: einen Längsschnitt einer nicht erfindungsgemäßen Ablenkvorrichtung mit einem verkippbaren Spiegel, der in Fig. 4a in einer axial nicht ausgelenkten Position und in Fig. 4b in seiner axial ausgelenkten, oberen Endposition gezeigt ist;
- Fig. 5: eine Draufsicht auf ein in Fig. 4 gezeigtes Substrat;
- Fig. 6: einen Längsschnitt einer nicht erfindungsgemäßen Ablenkvorrichtung mit einem verkippbaren Spiegel, der in einer axial nicht ausgelenkten Position gezeigt ist;
- Fig. 7: einen Längsschnitt einer nicht erfindungsgemäßen Ablenkvorrichtung mit einem verkippbaren Spiegel, der in einer axial nicht ausgelenkten Position gezeigt ist;
- Fig. 8: einen Längsschnitt einer nicht erfindungsgemäßen Ablenkvorrichtung mit einem verkippbaren Spiegel, der in seiner axial ausgelenkten, oberen Endposition gezeigt ist; und
- Fig. 9: eine Draufsicht auf eine in Fig. 8 gezeigte Federmembran.

In der folgenden Figurenbeschreibung werden für gleiche bzw. funktionsgleiche Bauteile identische Bezugszeichen verwendet.

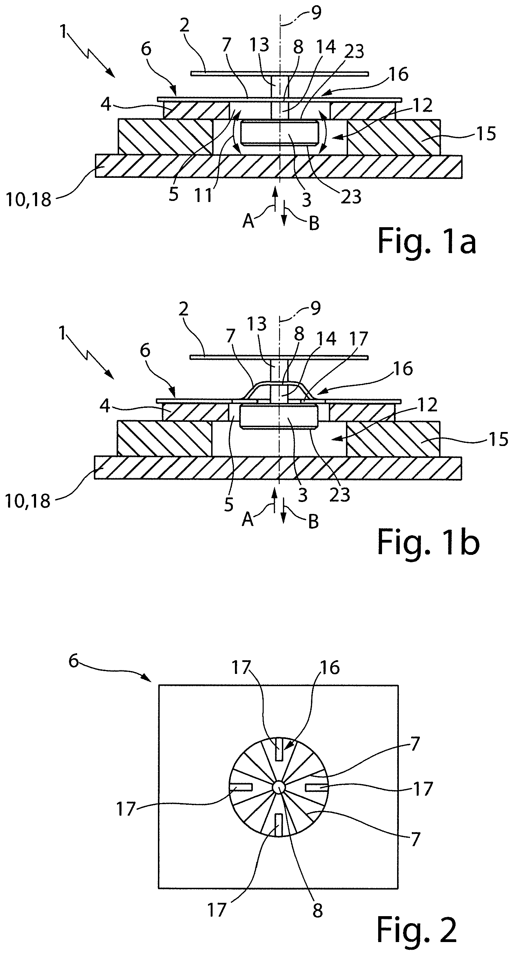

Die in **Fign. 1a, 1b** gezeigte Vorrichtung **1** dient zur zweidimensionalen Ablenkung eines Laserstrahls mittels eines zweidimensional kippbar gelagerten Spiegels **2.** Die Ablenkvorrichtung 1 weist neben dem Spiegel 2 folgende weitere Komponenten auf:
einen starr mit dem Spiegel 2 verbundenen Permanentmagneten **3,**
ein Substrat **4** mit einer Substratöffnung **5,**
eine an dem Substrat 4 vorgesehene Federmembran **6**, die sich in die Substratöffnung 5 erstreckende Federarme **7** und einen in der Substratöffnung 5 angeordneten, von den Federarmen 7 getragenen Mittelabschnitt **8** aufweist, welcher kippbar und in beide Richtungen **A**, **B** der Federmembran-Mittelachse **9** axial verschiebbar gelagert ist, wobei der Spiegel 2 an der einen, in Fig. 1 oberen Seite des Mittelabschnitts 8 befestigt ist, und
eine als Flachspulen-Leiterplatte ausgestaltete Magnetspule **10** zum Erzeugen eines Magnetfeldes, um den Permanentmagneten 3 samt Spiegel 2 gegen die Rückstellkraft der Federarme 7 um jede beliebige, rechtwinklig zur Mittelachse 9 verlaufende Kippachse des Mittelabschnitts 8 zu verkippen, wie dies durch Doppelpfeile **11** für die rechtwinklig zur Zeichenebene verlaufende Kippachse des Mittelabschnitts 8 angedeutet ist.

Der Permanentmagnet 3 und die Magnetspule 10 bilden somit gemeinsam einen insgesamt mit **12** bezeichneten elektromagnetischen Antrieb zum Verkippen des Spiegels 2 gegen die Rückstellkraft der Federarme 7. Der Spiegel 2 ist mittels eines oberen Abstandshalters **13** an der oberen Seite und der Permanentmagnet 3 mittels eines unteren Abstandshalters **14** an der unteren Seite des Mittelabschnitts 8 befestigt und somit an der Federmembran 6 hängend gehalten. Das Substrat 4 ist mittels eine Rahmens **15** auf der Flachspulen-Leiterplatte 10 befestigt, die sich somit unterhalb des Permanentmagneten 3 befindet. Bevorzugt sind der Spiegel 2 und der obere Abstandhalter 13 einstückig aus einem SOI(Silicon-on-Insulator)-Siliziumwafer (z.B. Si/SiO2/Si-Sandwich) geätzt, wobei der obere Abstandhalter 13 aus einer anderen Siliziumschicht als der Spiegel 2 besteht. Alternativ kann der obere Abstandhalter 13 auch ein eigenes Bauteil sein, das separat am Spiegel 2 montiert ist.

Eine über die beim magnetfeldbewirkten Verkippen des Spiegels 2 hinausgehende, axiale Auslenkung des Mittelabschnittes 8 nach oben (Richtung A) ist durch eine obere Endanschlageinrichtung **16** begrenzt, die mit dem Permanentmagneten 3 zusammenwirkt. Wie in **Fig. 2** gezeigt, ist die Endanschlageinrichtung 16 durch mehrere, hier lediglich beispielhaft vier Endanschlagarme **17** der Federmembran 6 gebildet, die in die Substratöffnung 5 bis in die Bewegungsbahn des Permanentmagneten 3 hinein vorstehen, um mit ihren freien Enden die axiale Bewegung des Permanentmagneten 3 nach oben zu stoppen. Dazu weisen die Endanschlagarme 17 eine deutlich höhere Federsteifigkeit, z.B. eine größere Breite, als die Federarme 7 auf. Die Endanschlagarme 17 sind in gleichen Winkelabständen zueinander und in ausreichendem Abstand zu den Federarmen 7 angeordnet, um deren Bewegung nicht zu blockieren. Die in Fig. 1b gezeigte maximale Auslenkung des Spiegels 2 nach oben ist durch die Endanschlageinrichtung 16 auf typischerweise 300 µm begrenzt.

Die Federmembran 6 ist bevorzugt eine Silizium-Federmembran, deren Mittelabschnitt 8 und Feder- und Endanschlagarme 7, 17 direkt in dem Devicelayer eines SOI(Silicon-on-Insulator)-Siliziumsubstrats 4 durch Ätzen hergestellt oder als Beschichtung auf das Substrat 4 aufgebracht sind, wobei die Federarme 7, wie gezeigt, gerade, aber auch spiralförmig, zickzack-förmig oder S-förmig verlaufen können.

Die Flachspulen-Leiterplatte 10 unterhalb des Permanentmagneten 3 begrenzt eine über die beim magnetfeldbewirkten Verkippen des Spiegels 2 hinausgehende, axiale Auslenkung des Mittelabschnittes 8 nach unten (Richtung B) und bildet somit eine mit dem Permanentmagneten 3 zusammenwirkende untere Endanschlageinrichtung **18.** Die maximale Auslenkung des Spiegels 2 nach unten ist durch die untere Endanschlageinrichtung 18 auf typischerweise 200 µm begrenzt.

Die beiden Endanschlageinrichtungen 16, 18 limitieren die vertikalen Auslenkungen der Federarme 7 nach oben und nach unten, wie sie bei großen vertikalen Beschleunigungen oder Vibrationen, z.B. aufgrund von Stößen, auftreten können, und sind außerhalb des antriebsbedingten, maximalen Kippwinkelbereichs des Spiegels 2 von z.B. ± 10° angeordnet. Die Federmembran 6 ist so dimensioniert, dass bei Auslenkung bis zu den beiden Endanschlageinrichtungen 16, 18 sich die mechanischen Spannungen der Federmembran 6 unterhalb der plastischen Verformungsgrenze oder der Bruchgrenze befinden.

Bei einer nicht gezeigten Ausführungsform ist die Magnetspule alternativ als gewickelte Spule am Rahmen 15 und somit außerhalb der Bewegungsbahn des Permanentmagneten 3 angeordnet. Bei einer solchen seitlichen Spule kann unterhalb des Permanentmagneten 3 eine Anschlagplatte als untere Endanschlageinrichtung 18 befestigt sein.

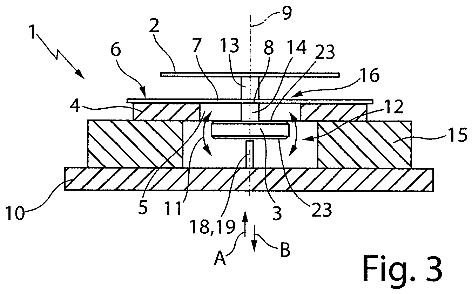

Von Fig. 1 unterscheidet sich die in **Fig. 3** gezeigte Ablenkvorrichtung 1 dadurch, dass hier die untere Endanschlageinrichtung 18 durch einen von der Flachspulen-Leiterplatte 10 hochstehenden Dorn **19** gebildet ist, an dem der Permanentmagnet 3 in seiner axial ausgelenkten, unteren Endstellung anliegt. Bei gleichem maximalem Kippwinkelbereich des Spiegels 2 kann der Dorn 19 in kleinerem Abstand zum Permanentmagnet 3 als die Flachspulen-Leiterplatte 10 platziert werden.

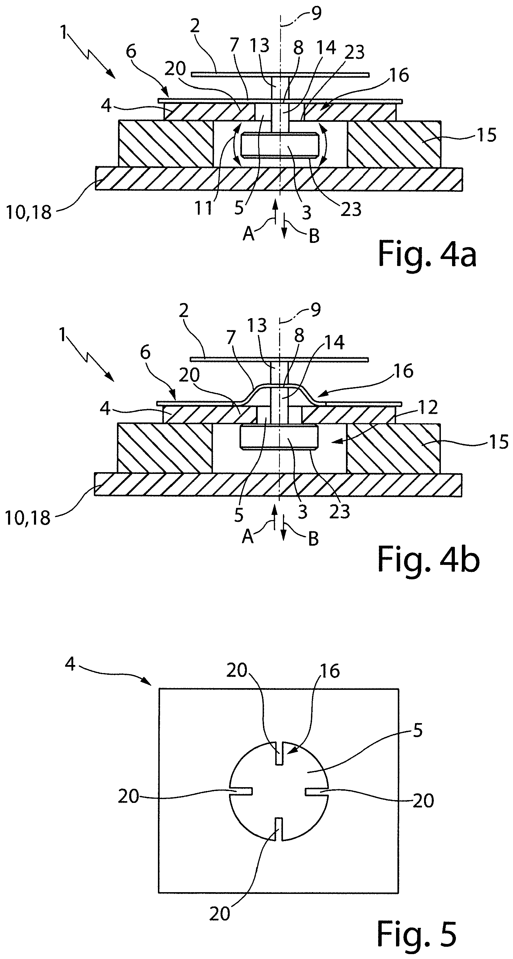

Von Fig. 1 unterscheidet sich die in **Fig. 4a, 4b** gezeigte Ablenkvorrichtung 1 dadurch, dass hier die obere Endanschlageinrichtung 16 durch mehrere, hier lediglich beispielhaft vier Endanschlagarme **20** des Substrats 4 gebildet ist, die in die Substratöffnung 5 bis in die Bewegungsbahn des Permanentmagnets 3 hinein vorstehen, um mit ihren freien Enden die axiale Bewegung des Permanentmagneten 3 nach oben zu stoppen. Die Endanschlagarme 20 können in der Handlelayer eines SOI(Silicon-on-Insulator)-Siliziumsubstrats 4 durch Ätzen hergestellt sein und sind, wie in **Fig. 5** gezeigt, bevorzugt in gleichen Winkelabständen zueinander angeordnet. Die Endanschlagarme 20 müssen in genügenden seitlichen Abstand zu den Federarmen 7 angeordnet sein, um deren Bewegung nicht zu blockieren.

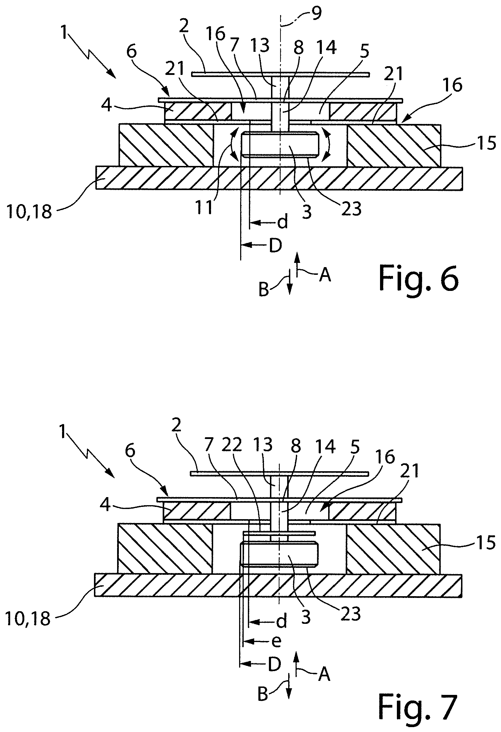

Von Fig. 1 unterscheidet sich die in **Fig. 6** gezeigte Ablenkvorrichtung 1 dadurch, dass hier der Permanentmagnet 3 zwischen der Flachspulen-Leiterplatte 10 und einer Lochblende **21** angeordnet ist. Die Lochblende 21 ist auf der der Federmembran 6 gegenüberliegenden Unterseite des Substrats 4 befestigt, wobei der Lochdurchmesser **d** kleiner als der Durchmesser **D** des Permanentmagneten 3 ist. Die Lochblende 21 kann eine Lochfolie, wie z.B. eine Polyimid-Folie, sein. Die Lochblende 21 bildet die obere Endanschlageinrichtung 16 und steht in die Substratöffnung 5 bis in die Bewegungsbahn des Permanentmagneten 3 hinein vor, um mit ihrem Öffnungsrand die axiale Bewegung des Permanentmagneten 3 nach oben zu stoppen. Alternativ kann die Lochblende 21 auch Endanschlagarme aufweisen, die soweit zur Mitte reichen, dass sie den Permanentmagneten 3 bei vertikaler Bewegung nach oben stoppen

Von Fig. 6 unterscheidet sich die in **Fig. 7** gezeigte Ablenkvorrichtung 1 dadurch, dass hier die obere Endanschlageinrichtung 16 durch die Lochblende 21 und eine Anschlagplatte (z.B. Aluminiumplättchen) **22** gebildet ist, die zwischen Permanentmagnet 3 und Lochblende 21 am Abstandshalter 14 befestigt ist. Der Durchmesser e der Anschlagplatte 22 ist größer als der Lochdurchmesser d und kann, wie in Fig.7 gezeigt, kleiner als der Durchmesser D des Permanentmagneten 3 sein. Die Lochblende 21 steht in die Substratöffnung 5 bis in die Bewegungsbahn der Anschlagplatte 22 hinein vor, um mit ihrem Öffnungsrand oder mit ihren Endanschlagarmen die axiale Bewegung der Anschlagplatte 22 nach oben zu stoppen. Anstelle einer separaten Anschlagplatte kann der untere Abstandshalter 14 auch einen mindestens radial nach außen vorstehenden Vorsprung 22, wie z.B. eine Ausbuchtung oder einen Ringbund, aufweisen, der mit der Lochblende 21 zusammenwirkt.

Statt mit einer separaten Lochblende kann die Anschlagplatte 22 oder der mindestens eine radial nach außen vorstehende Vorsprung alternativ auch mit den in Fign. 1 und 4 beschriebenen Endanschlagarmen 17, 20 der Federmembran 6 bzw. des Substrats 4 zusammenwirken.

Wie in den Zeichnungen gezeigt, kann der Permanentmagnet 3 ober- und unterseitig mit einem Polymerüberzug **23** versehen sein, um den Aufprall an der Endanschlageinrichtung 16, 18 zusätzlich zu dämpfen. Alternativ oder zusätzlich kann auch die Endanschlageinrichtung 16, 18 einen dämpfenden Polymerüberzug aufweisen.

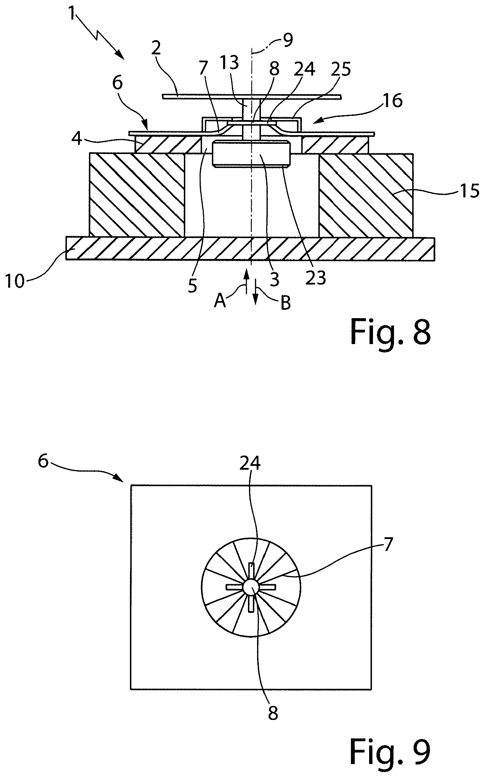

In **Fign. 8 und 9** ist eine weitere Ablenkvorrichtung 1 gezeigt, bei der der Mittelabschnitt 8 sich radial nach außen erstreckende Endanschlagarme **24** aufweist und oberhalb der Federmemban 6 eine am Substrat 4 befestigte Lochblende **25** angeordnet ist. Die Lochblende 25 bildet die obere Endanschlageinrichtung 16 und steht in die Substratöffnung 5 bis in die Bewegungsbahn der Endanschlagarme 24 hinein vor, um die axiale Bewegung der Federmemban 6 und des Permanentmagneten 3 nach oben zu stoppen. Fig. 8 zeigt den Spiegel 2 in seiner axial ausgelenkten, oberen Endposition, in der die Endanschlagarme 24 an der Lochblende 25 anliegen.

Anders als bei den gezeigten Ablenkvorrichtungen, bei denen die Magnetspule 10 ortsfest und der Permanentmagnet 3 starr mit dem Spiegel 2 verbunden sind, sind bei nicht gezeigten Ausführungsformen der Permanentmagnet 3 ortsfest und die Magnetspule 10 starr mit dem Spiegel 2 verbunden. In diesem Fall kann die beweglich gelagerte Magnetspule 10 mit den Endanschlageinrichtungen 16, 18 zusammenwirken.

Anstelle des magnetischen Antriebs 12 kann auch ein elektrostatischer Antrieb eingesetzt werden, der eine ortsfeste erste Elektrode und eine starr mit dem Spiegel 2 verbundene zweiten Elektrode aufweist. Im elektrischen Feld des elektrostatischen Antriebs wird die zweite Elektrode gegen die Rückstellkraft der Federarme verkippt, wobei die zweite Elektrode mit den Endanschlageinrichtungen 16, 18 zusammenwirkt.

## Patentansprüche

1. Vorrichtung (1) zur zweidimensionalen Ablenkung eines Laserstrahls, aufweisend:
ein Substrat (4) mit einer Substratöffnung (5),
eine an dem Substrat (4) vorgesehene Federmembran (6), die sich in die Substratöffnung (5) erstreckende Federarme (7) und einen in der Substratöffnung (5) angeordneten, von den Federarmen (7) getragenen Mittelabschnitt (8) aufweist, welcher zweidimensional kippbar und in beide Richtungen (A, B) der sich rechtwinklig zur Federmembranebene erstreckenden Federmembran-Mittelachse (9) axial verschiebbar gelagert ist, einen Spiegel (2), der an dem Mittelabschnitt (8) der Federmembran (6) befestigt ist, und
einen magnetischen oder elektrostatischen Antrieb (12) zum Verkippen des Spiegels (2) gegen die Rückstellkraft der Federarme (7),
**dadurch gekennzeichnet,**
**dass** die Federmembran (6) mindestens einen Endanschlagarm (17) aufweist, der eine höhere Federsteifigkeit als die Federarme (7) aufweist und mit einem freien Ende in die Substratöffnung (5) bis in die Bewegungsbahn eines starr am Spiegel (2) befestigten Bauteils (3; 22) hinein vorsteht,
um durch Zusammenwirken mit dem Bauteil (3; 22) eine über die beim antriebsbedingten Verkippen des Spiegels (2) hinausgehende, axiale Auslenkung des Mittelabschnittes (8) zumindest in einer axialen Richtung (A) zu begrenzen.

2. Vorrichtung nach Anspruch 1, **dadurch gekennzeichnet, dass** das mit dem mindestens einen Endanschlagarm (17) zusammenwirkende Bauteil (3; 22) auf der dem Spiegel (2) gegenüberliegenden Seite des Mittelabschnittes (8) angeordnet, insbesondere an der gegenüberliegenden Seite des Mittelabschnittes (8) befestigt ist.

3. Vorrichtung nach einem der vorhergehenden Ansprüche, **dadurch gekennzeichnet, dass** das mit dem mindestens einen Endanschlagarm (17) zusammenwirkende Bauteil die Federmembran (6) oder ein Permanentmagnet (3) oder eine Magnetspule (10) eines magnetischen Antriebs (12), eine Elektrode eines elektrostatischen Antriebs oder ein weiteres Bauteil (22) ist.

4. Vorrichtung nach Anspruch 3, **dadurch gekennzeichnet, dass** das weitere Bauteil durch eine separate Anschlagplatte (22) oder durch mindestens einen radial nach außen vorstehenden Vorsprung eines zwischen Permanentmagnet (3) und Federmembran (7) befindlichen Abstandshalters (14) gebildet ist.

5. Vorrichtung nach einem der vorhergehenden Ansprüche, **dadurch gekennzeichnet, dass** eine über die beim antriebsbedingten Verkippen des Spiegels (2) hinausgehende axiale Auslenkung des Mittelabschnittes (8) durch eine weitere Endanschlageinrichtung (18), die mit einem starr am Spiegel (2) befestigten Bauteil (3) zusammenwirkt, auch in der anderen axialen Richtung (B) begrenzt ist.

6. Vorrichtung nach Anspruch 5, **dadurch gekennzeichnet, dass** die weitere Endanschlageinrichtung (18) durch einen in der Bewegungsbahn des Bauteils (3) angeordneten Endanschlag, insbesondere durch einen axial vorstehenden Dorn (19) oder durch eine Anschlagplatte (10), gebildet ist.

7. Vorrichtung nach einem der vorhergehenden Ansprüche, **dadurch gekennzeichnet, dass** zwischen dem mindestens einen Endanschlagarm (17) bzw. der weiteren Endanschlageinrichtung (18) und dem damit zusammenwirkenden Bauteil (3; 22) ein Dämpfer (23) angeordnet, insbesondere an dem mindestens einen Endanschlagarm (17), der weiteren Endanschlageinrichtung (18) oder dem Bauteil (3; 22) befestigt ist.

8. Vorrichtung nach einem der vorhergehenden Ansprüche, **dadurch gekennzeichnet, dass** die Ablenkvorrichtung (1) in MEMS-Technologie ausgeführt ist.

## Claims

1. A device (1) for the two-dimensional deflection of a laser beam, comprising:
a substrate (4) having a substrate opening (5),
a spring membrane (6), which is provided on the substrate (4), and which has spring arms (7) extending into the substrate opening (5) and a middle section (8), which is arranged in the substrate opening (5) and supported by the spring arms (7), and which is mounted so it is two-dimensionally tiltable and axially displaceable in both directions (A, B) of the spring membrane middle axis (9), which extends perpendicular to the spring membrane plane,
a mirror (2), which is fastened on the middle section (8) of the spring membrane (6), and
a magnetic or electrostatic drive (12) for tilting the mirror (2) against the restoring force of the spring arms (7),
**characterized in that**
the spring membrane (6) comprises at least one end stop arm (17), which has a higher spring stiffness than the spring arms (7) and protrudes with one free end into the substrate opening (5) up into the movement path of a component (3; 22), which is rigidly mounted on the mirror (2) in order to delimit in cooperation with the component (3; 22) an axial deflection of the middle section (8) which goes beyond that during the drive-related tilting of the mirror (2) at least in an axial direction (A).

2. The device as claimed in claim 1, **characterized in that** the component (3; 22) cooperating with the at least one end stop arm (17) is arranged on the side of the middle section (8) opposite to the mirror (2), in particular is fastened on the opposite side of the middle section (8).

3. The device as claimed in any one of the preceding claims, **characterized in that** the component cooperating with the at least one end stop arm (17) is the spring membrane (6) or a permanent magnet (3) or a solenoid coil (10) of a magnetic drive (12), an electrode of an electrostatic drive, or a further component (22).

4. The device as claimed in claim 3, **characterized in that** the further component is formed by a separate stop plate (22) or by at least one projection protruding radially outward of a spacer (14) located between permanent magnet (3) and spring membrane (7).

5. The device as claimed in any one of the preceding claims, **characterized in that** an axial deflection of the middle section (8) which goes beyond that during the drive-related tilting of the mirror (2) is delimited by a further end stop unit (18), which cooperates with a component (3) rigidly fastened on the mirror (2), also in the other axial direction (B).

6. The device as claimed in claim 5, **characterized in that** the further end stop unit (18) is formed by an end stop arranged in the movement path of the component (3), in particular by an axially protruding spike (19) or by a stop plate (10).

7. The device as claimed in any one of the preceding claims, **characterized in that** a damper (23) is arranged between the at least one end stop arm (17) or the further end stop unit (18) and the component (3; 22) cooperating therewith, in particular is fastened on the at least one end stop arm (17), the further end stop unit (18) or the component (3; 22).

8. The device as claimed in any one of the preceding claims, **characterized in that** the deflection device (1) is embodied in MEMS technology.

## Revendications

1. Dispositif (1) de déviation bidimensionnelle d'un rayon laser, présentant :
un substrat (4) comportant un orifice de substrat (5),
une membrane à ressort (6) prévue au niveau du substrat (4) et qui présente des bras à ressort (7) s'étendant dans l'orifice de substrat (5) et une section centrale (8) disposée dans l'orifice de substrat (5) et supportée par les bras un ressort (7) et qui peut basculer en deux dimensions et s'appuie de manière à pouvoir se déplacer axialement dans les deux sens (A, B) de l'axe médian (9) de la membrane à ressort s'étendant orthogonalement par rapport au plan de la membrane à ressort,
un miroir (2) qui est fixé à la section centrale (8) de la membrane à ressort (6) ; et
une commande magnétique ou électrostatique (12) pour basculer le ressort (2) à l'encontre de la force de réinitialisation des bras à ressort (7),
**caractérisé en ce que**
la membrane à ressort (6) présente au moins un bras de butée terminale (17) qui présente une résistance de ressort supérieure à celle des bras à ressort (7) et qui dépasse par une extrémité libre dans l'orifice de substrat (5) jusque dans la piste de mouvement d'une pièce (3 ; 22) fixée rigidement au miroir (2),
pour, par interaction avec la pièce (3 ; 22), limiter une déviation axiale allant au-delà du basculement par commande du miroir (2) de la section centrale (8) du moins dans un sens axial (A) .

2. Dispositif selon la revendication 1, **caractérisé en ce que** la pièce (3 ; 22) interagissant avec l'au moins un bras de butée terminale (17) est disposée sur la face opposée au miroir (2) de la section centrale (8), en particulier fixée à la face opposée de la section centrale (8).

3. Dispositif selon une des revendications précédentes, **caractérisé en ce que** la pièce interagissant avec l'au moins un bras de butée terminale (17) est la membrane à ressort (6) ou un aimant permanent (3) ou une bobine magnétique (10) d'une commande magnétique (12), une électrode d'une commande électrostatique ou une autre pièce (22) .

4. Dispositif selon la revendication 3, **caractérisé en ce que** l'autre pièce est constituée par une plaque de butée séparée (22) ou par au moins une saillie dépassant radialement vers l'extérieur d'un écarteur (14) se trouvant entre l'aimant permanent (3) et la membrane à ressort (7).

5. Dispositif selon une des revendications précédentes, **caractérisé en ce qu'**une déviation axiale allant au-delà du basculement par commande du miroir (2) de la section centrale (8) est limitée par un autre dispositif de butée terminale (18) qui interagit avec une pièce (3) fixée rigidement au miroir (2), également dans l'autre sens axial (B).

6. Dispositif selon la revendication 5, **caractérisé en ce que** l'autre dispositif de butée terminale (18) est constitué par une butée terminale disposée dans la piste de mouvement de la pièce (3), en particulier par un mandrin (19) dépassant axialement ou par une plaque de butée (10).

7. Dispositif selon une des revendications précédentes, **caractérisé en ce que**, entre l'au moins un bras de butée terminale (17) ou l'autre dispositif de butée terminale (18) et la pièce (3 ; 22) interagissant avec, est disposé un amortisseur (23), en particulier fixé à l'au moins un bras de butée terminale (17), l'autre dispositif de butée terminale (18) ou la pièce (3 ; 22).

8. Dispositif selon une des revendications précédentes, **caractérisé en ce que** le dispositif de déviation (1) est réalisé en technologie MEMS.
